(19) 

Europäisches
Patentamt
European
Patent Office
Office européen
des brevets

(11)  **EP 4 451 833 A1**

(12)  **EUROPEAN PATENT APPLICATION**
published in accordance with Art. 153(4) EPC

(43) Date of publication:
**23.10.2024  Bulletin 2024/43**

(21) Application number: **22907760.7**

(22) Date of filing: **25.11.2022**

(51) International Patent Classification (IPC):
*H10K 99/00* (2023.01)        *H10K 71/00* (2023.01)
*C23C 14/04* (2006.01)

(52) Cooperative Patent Classification (CPC):
**C23C 14/04; H10K 71/00; H10K 99/00**

(86) International application number:
**PCT/KR2022/018858**

(87) International publication number:
**WO 2023/113291 (22.06.2023 Gazette 2023/25)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(30) Priority:  **14.12.2021  KR 20210178252**

(71) Applicant: **LG Innotek Co., Ltd.**
**Seoul 07796 (KR)**

(72) Inventor: **CHANG, Woo Young**
**Seoul 07796 (KR)**

(74) Representative: **Plasseraud IP**
**104 Rue de Richelieu**
**CS92104**
**75080 Paris Cedex 02 (FR)**

(54)  **METAL PLATE AND DEPOSITION MASK FOR OLED PIXEL DEPOSITION INCLUDING SAME**

(57)      A metal plate used to manufacture a deposition mask for OLED pixel deposition, the metal plate comprises a first region; and a second region intersecting the first region, wherein the metal plate includes an invar containing iron and nickel, a first residual stress of the first region and a second residual stress of the second region are 5 mm or less, a ratio of the first residual stress and the second residual stress is 1:0.2 to 0.7, the first residual stress is a residual stress of an arbitrary first sample metal plate of a size of X mm*Y mm (horizontal*vertical) in which the first region is a horizontal region, the second residual stress is a residual stress of an arbitrary second sample metal plate of a size of Y mm*X mm (horizontal*vertical) in which the second region is a horizontal region, the X is 200 mm to 220 mm, and the Y is 140 mm to 160 mm, and the residual stress is defined by Equation 1 below when a thickness of a region after 5% to 10% of a length of a long width region from one end of each of the first sample metal plate and the second sample metal plate is etched to be 30% to 70% of a thickness of the metal plate and etched sample metal plates are mounted on a horizontal table.

[Equation 1]

$$\text{residual stress} = H/L$$

(H is a maximum height (mm) at which an etched region of a sample metal plate is bent up from an upper surface of the horizontal table, and L is a length (mm) of a first region in which an etched region is formed in a sample metal plate)

[FIG. 2]

**Description**

[Technical Field]

An embodiment relates to a metal plate and a deposition mask for OLED pixel deposition.

[Background Art]

A display device is applied and used in various devices. For example, the display device is applied and used not only in a small device such as a smartphone and a tablet PC, but also in a large device such as a TV, a monitor, and a public display (PD). In particular, recently, demand for ultra-high resolution (UHD) of 500 PPI (Pixel Per Inch) or higher is increasing, and a high-resolution display device is being applied to a small device and a large device. Accordingly, interest in technologies for low-power and high-resolution implementation is increasing.

Generally used display devices can be largely divided into LCD (Liquid Crystal Display) and Organic Light Emitting Diode (OLED) depending on a driving method.

The LCD is a display device driven by using a liquid crystal, and has a structure in which a light source including a CCFL (Cold Cathode Fluorescent Lamp) or an LED (Light Emitting Diode) is disposed under the liquid crystal. The LCD is a display device driven by adjusting the amount of light emitted from the light source by using the liquid crystal disposed on the light source.

In addition, the OLED is a display device driven by using an organic material and does not require a separate light source. Accordingly the OLED can be driven at low power by the organic material performing a function of the light source. In addition, the OLED can express infinite contrast ratio and have a response speed about 1000 times faster than LCD and an excellent viewing angle. Accordingly, the OLED is attracting attention as a display device that can replace LCD.

In particular, the organic material included in a light emitting layer in the OLED may be deposited on a substrate by a deposition mask called a fine metal mask (FMM), and the deposited organic material may be formed in a pattern corresponding to a pattern formed in the deposition mask and may function as a pixel. The deposition mask is generally manufactured using an invar alloy metal plate including iron (Fe) and nickel (Ni). In this case, a through hole passing through one surface and the other surface is formed in the metal plate. The through hole may be formed at a position corresponding to a pixel pattern. Accordingly, organic materials such as red, green, and blue can pass through the through hole of the metal plate and be deposited on the substrate, and a pixel pattern can be formed on the substrate.

On the other hand, the invar alloy metal plate used as the deposition mask can allow a through hole to be formed in the metal plate after going through a pretreatment process of modifying the thickness and a surface of the metal plate.

In this case, a stress distribution inside the metal plate may be changed by the pretreatment process of the metal plate. Accordingly, the metal plate may be bent due to non-uniformity in the stress distribution inside the metal plate, and a waviness of the metal plate may increase.

Accordingly, when each deposition mask is cut into an unit size after forming a through hole in a metal plate on which a pretreatment process has been performed, the deposition mask may be bent due to this stress.

Therefore, when depositing an organic material through a deposition mask, there is a gap between the deposition mask and the substrate on which the organic material is to be deposited, and thus deposition efficiency may be deteriorated.

Therefore, a new deposition mask capable of controlling a warpage and a waviness of the metal plate caused by the pretreatment process of the metal plate is required.

[Disclosure]

[Technical Problem]

The embodiment provides a metal plate with reduced warpage and waviness and a deposition mask manufactured using the same.

[Technical Solution]

A metal plate used to manufacture a deposition mask for OLED pixel deposition, the metal plate comprises a first region; and a second region intersecting the first region, wherein the metal plate includes an invar containing iron and nickel, a first residual stress of the first region and a second residual stress of the second region are 5 mm or less, a ratio of the first residual stress and the second residual stress is 1:0.2 to 0.7, the first residual stress is a residual stress of an arbitrary first sample metal plate of a size of X mm*Y mm (horizontal*vertical) in which the first region is a horizontal region, the second residual stress is a residual stress of an arbitrary second sample metal plate of a size of Y mm*X mm (horizontal*vertical) in which the second region is a horizontal region, the X is 200 mm to 220 mm, and the Y is 140 mm to 160 mm, and the residual stress is defined by Equation 1 below when a thickness of a region after 5% to 10% of a length of a long width region from one end of each of the first sample metal plate and the second sample metal plate is etched to be 30% to 70% of a thickness of the metal plate and etched sample metal plates are mounted on a horizontal table.

[Equation 1]

$$\text{residual stress} = H/L$$

(H is a maximum height (mm) at which an etched region of a sample metal plate is bent up from an upper surface of the horizontal table, and L is a length (mm) of a first region in which an etched region is formed in a sample metal plate)

[Advantageous Effects]

The metal plate according to an embodiment may control residual stress and waviness of the metal plate remaining after the pretreatment process within a set range, and may improve a problem of a gap between the deposition mask manufactured by the metal plate and the deposition substrate. Therefore, when the organic material is deposited on the deposition substrate through the deposition mask manufactured by the metal plate, the deposition efficiency is improved.

[Description of Drawings]

FIG. 1 is a cross-sectional view showing an organic material deposition apparatus to which a deposition mask is applied according to an embodiment.
FIG. 2 is a cross-sectional view for explaining a contact relationship between a deposition mask and a deposition substrate according to an embodiment.
FIG. 3 is a view for explaining a pretreatment process of a metal plate for manufacturing a deposition mask according to an embodiment.
FIGS. 4 and 5 are views for explaining a sample metal plate manufactured using a metal plate for manufacturing a deposition mask according to an embodiment.
FIG. 6 is a view for explaining a method of measuring a residual stress of a metal plate for manufacturing a deposition mask according to an embodiment.
FIG. 7 is a view for explaining a method of measuring a waviness of a metal plate for manufacturing a deposition mask according to an embodiment.
FIG. 8 is a plan view of a deposition mask according to an embodiment.
FIG. 9 is a view for explaining a T/P (Total Pitch) and a straightness of a deposition mask according to an embodiment.

[Best Mode]

Hereinafter, embodiments of the present disclosure will be described in detail with reference to the accompanying drawings. However, the spirit and scope of the present disclosure is not limited to a part of the embodiments described, and may be implemented in various other forms, and within the spirit and scope of the present disclosure, one or more of the elements of the embodiments may be selectively combined and replaced. In addition, unless expressly otherwise defined and described, the terms used in the embodiments of the present disclosure (including technical and scientific terms) may be construed the same meaning as commonly understood by one of ordinary skill in the art to which the present disclosure belongs, and the terms such as those defined in commonly used dictionaries may be interpreted as having a meaning that is consistent with their meaning in the context of the relevant art.

In addition, the terms used in the embodiments of the present disclosure are for describing the embodiments and are not intended to limit the present disclosure. In this specification, the singular forms may also include the plural forms unless specifically stated in the phrase, and may include at least one of all combinations that may be combined in A, B, and C when described in "at least one (or more) of A (and), B, and C".

Further, in describing the elements of the embodiments of the present disclosure, the terms such as first, second, A, B, (a), and (b) may be used. These terms are only used to distinguish the elements from other elements, and the terms are not limited to the essence, order, or order of the elements.

In addition, when an element is described as being "connected", "coupled", or "contacted" to another element, it may include not only when the element is directly "connected" to, "coupled" to, or "contacted" to other elements, but also when the element is "connected", "coupled", or "contacted" by another element between the element and other elements.

In addition, when described as being formed or disposed "on (over)" or "under (below)" of each element, the "on (over)" or "under (below)" may include not only when two elements are directly connected to each other, but also when one or more other elements are formed or disposed between two elements.

Further, when expressed as "on (over)" or "under (below)", it may include not only an upper region but also a lower region based on one element.

Hereinafter, a deposition mask according to an embodiment will be described with reference to the drawings.

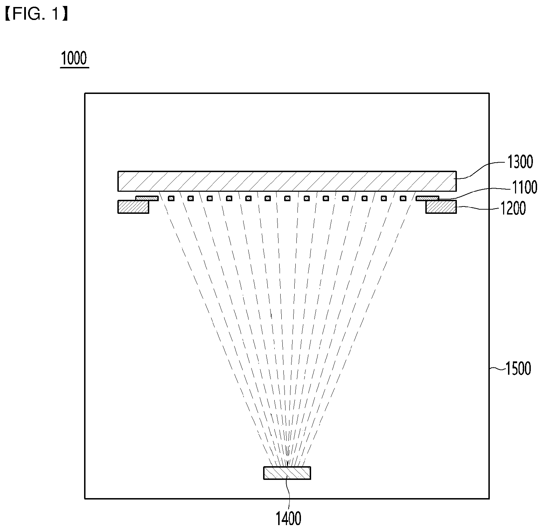

FIG. 1 is a view illustrating an organic material deposition apparatus to which a deposition mask according to an embodiment is applied.

Referring to FIG. 1, an organic material deposition apparatus 1000 includes a deposition mask 1100, a mask frame 1200, a deposition substrate 1300, an organic material deposition container 1400, and a vacuum chamber 1500.

The deposition mask 1100, the mask frame 1200, the deposition substrate 1300, and the organic material deposition container 1400 are accommodated in the vacuum chamber 1500. Accordingly, a deposition process through the deposition mask 1100 may be performed in a vacuum atmosphere.

The deposition substrate 1300 is a substrate used for manufacturing a display device. For example, the deposition substrate 1300 may be an organic material deposition substrate forming an OLED pixel pattern. Organic material patterns of red, green, and blue are formed on the deposition substrate 1300 to form pixels that are the three primary colors of light. That is, an RGB pattern is formed on the deposition substrate 1300.

The deposition mask 1100 is disposed on one surface of the deposition substrate 1300. In detail, the deposition mask 1100 is disposed on a deposition surface on which an organic material is deposited among both surfaces of the deposition substrate 1300. Also, the deposition mask 1100 is fixed by the mask frame 1200.

Accordingly, the organic material passes through a through hole TH formed in the deposition mask 1100, an organic material is deposited on the deposition surface of the deposition substrate 1300, thereby forming an RGB pattern on the deposition surface of the deposition substrate 1300.

The organic material deposition container 1400 may be a crucible. An organic material is disposed inside the crucible. A heat source and/or current are supplied to the crucible, which is the organic material deposition container 1400, in the vacuum chamber 1500. Accordingly, the organic material passes through the deposition mask 1100, and the organic material is deposited on the deposition surface of the deposition substrate 1300.

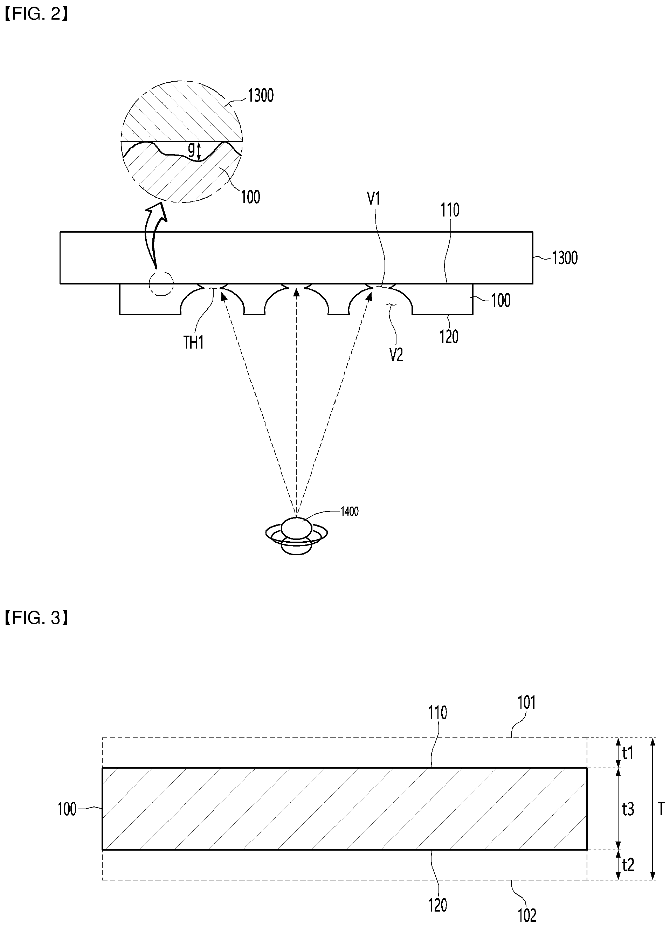

FIG. 2 is a view for explaining an arrangement relationship between the deposition mask 1100 and the deposition substrate 1300.

Referring to FIG. 2, the deposition mask 1100 is disposed on a deposition surface of the deposition substrate 1300. In detail, the deposition mask 1100 is disposed in direct or indirect contact with the deposition surface of the deposition substrate 1300.

The deposition mask 1100 is formed by forming a plurality of through holes THs in a metal plate 100 including iron and nickel. In detail, a plurality of through holes THs formed through an etching process are formed in a metal plate 100 including an invar alloy including iron and nickel to form the deposition mask 1100.

Specifically, the metal plate 100 includes a first surface 101 and a second surface 102 opposite to each other. A first surface hole V1 is formed at the first surface 101 of the metal plate 100, and a second surface hole V2 is formed at the second surface 102 of the metal plate 100. A size of the first surface hole V1 is smaller than a size of the second surface hole V2. That is, a diameter of the first surface hole V1 is smaller than a diameter of the second surface hole V2.

The second surface hole V2 is disposed to face the organic material deposition container 1400. Accordingly, the organic material of the organic material deposition container 1400 is introduced. The first surface hole V1 is a region through which the organic material introduced from the second surface hole V2 passes. Accordingly, the organic material passing through the first surface hole V1 is deposited on the deposition substrate 1300.

The first surface hole V1 and the second surface hole V2 are formed to partially pass through the metal plate 100. For example, ta depth of the first surface hole V1 is smaller than a depth of the second surface hole V2. Also, the first surface hole V1 and the second surface hole V2 are disposed at positions overlapping each other in a thickness direction of the metal plate 100 and are formed to communicate with each other.

Accordingly, a plurality of through holes TH formed by communicating the first surface hole V1 and the second surface hole V2 are formed in the metal plate 100.

The deposition mask 1100 is manufactured by cutting the metal plate 100 having a plurality of through-holes THs into a set unit area size. For example, the deposition mask 1100 may be formed by cutting into a stick shape having a set unit area size.

The deposition mask 1100 is disposed such that the first surface hole V1 of the deposition mask 1100 is in contact with the deposition surface of the deposition substrate 1300.

Before the metal plate 100 forms the through hole TH, a pretreatment process for reducing the thickness of the metal plate 100 is performed. In the metal plate 100, a distribution of an internal stress of the metal plate, that is, tensile stress and compressive stress may be changed by a pretreatment process. The metal plate may be bent by the change in distribution of internal stress as described above. Accordingly, a waviness of the surface of the metal plate, that is, a surface waveform may be changed.

The bending and increase in waviness of the metal plate 100 affect a straightness of the deposition mask 1100 manufactured by the metal plate 100.

That is, when an etching process is performed to form the through hole TH in the metal plate 100, a process of tensioning the metal plate to flatten a curved metal plate is performed. In this case, when the bending of the metal plate increases, a tensile force for tensioning the metal plate increases. Accordingly, when a through hole is formed in the metal plate 100 and a deposition mask is formed by cutting the metal plate into a set size, a residual stress increases due to tension, and thus a straightness, that is, the bending, of the deposition mask may increase.

Accordingly, when a deposition process is performed on a deposition substrate using the deposition mask, a gap g may be formed between the deposition mask and the deposition substrate. Accordingly, the deposition efficiency of the deposition mask is deteriorated. In addition, a thickness of the organic material through a deposition region of the deposition mask varies depending on a region, and accordingly, there is a problem in that a thickness of the organic pattern deposited on the deposition substrate becomes non-uniform.

Hereinafter, a metal plate capable of solving the above problems and a deposition mask manufactured thereby will be described.

FIG. 3 is a view for explaining a pretreatment process of a metal plate according to an embodiment.

Referring to FIG. 3, a metal plate 100 includes one surface 101 and the other surface 102 opposite to the one surface 101.

The metal plate 100 includes iron (Fe) and nickel (Ni). Specifically, the metal plate 100 may include about 60 to 65 wt% of iron, and may include about 35 to 40 wt% of nickel. Specifically, the metal plate 100 may include about 63.5 to 64.5 wt% of iron, and may include about 35.5 to 36.5 wt% of nickel. In addition, the metal plate 100 may further include at least one element among carbon (C), silicon (Si), sulfur (S), phosphorus (P), manganese (Mn), titanium (Ti), cobalt (Co), copper (Cu), silver (Ag), vanadium (V), niobium (Nb), indium (In), and antimony (Sb) in an amount of about 1 wt% or less.

One surface 101 and the other surface 102 of the metal plate 100 are etched. In detail, both surfaces of the metal plate 100 are etched through a chemical polishing process using an etching solution that may etch the metal plate 100. For example, one surface 101 of the metal plate 100 is etched to have a thickness (t1) in a range of 20% to 30% of a total thickness (T) of the metal plate 100, and the other surface 102 of the metal plate 100 is etched to have a thickness t2 in a range of 20% to 30% of the total thickness T of the metal plate 100.

Accordingly, the metal plate 100 includes a first surface 110 and a second surface 120 opposite to the first surface 110 by the pretreatment process. A thickness of the metal plate 100 is reduced by the pretreatment process. Specifically, the metal plate 100 has a thickness t3 of 5 $\mu$m to 30 $\mu$m after the pretreatment process. More specifically, the metal plate 100 has a thickness of 15 $\mu$m to 25 $\mu$m after the pretreatment process.

As the metal plate 100 is pretreated by a chemical polishing process, it is possible to prevent the bending or waviness of the metal plate 100 generated in the pretreatment process from increasing.

That is, internal stresses such as compressive stress and tensile stress contained in a raw material of the metal plate 100 are not changed by other forces, and the internal stress is removed by an etching process. Accordingly, the embodiment can minimize the occurrence of residual stress inside the metal plate 100 after the pretreatment process.

Accordingly, the residual stress inside the metal plate 100 after the pretreatment process may be minimized, and the waviness of the surface of the metal plate 100 may be minimized.

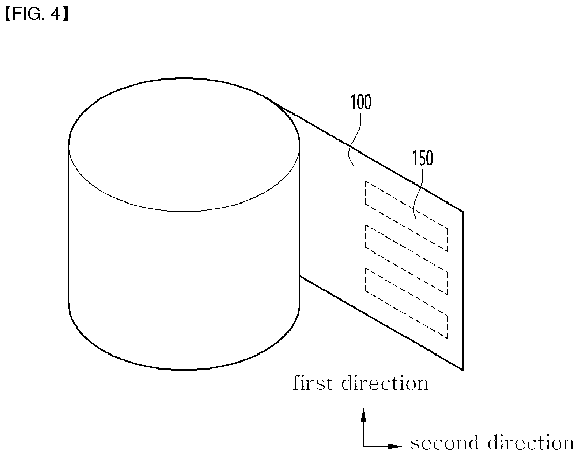

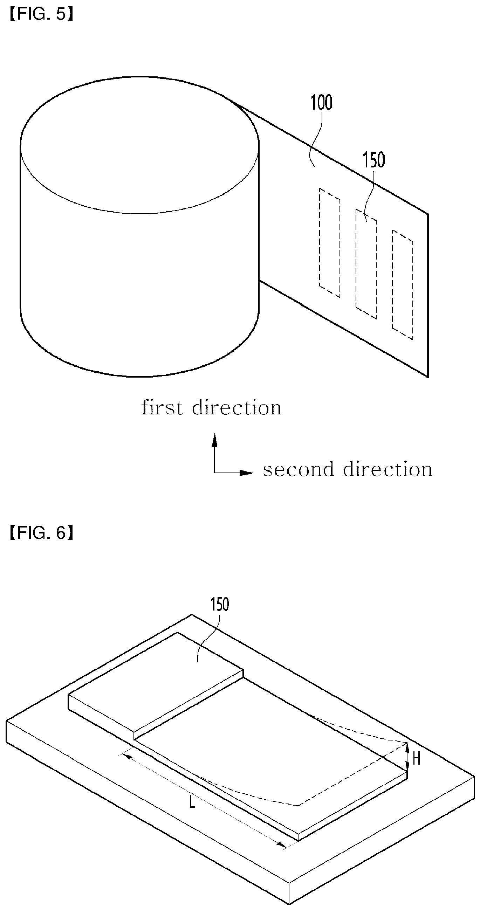

FIGS. 4 and 5 are views for explaining a sample metal plate manufactured using a metal plate according to an embodiment. In addition, FIG. 6 is a view for explaining a method of measuring a residual stress of a metal plate according to an embodiment. That is, FIG. 6 is a view for describing a method of measuring residual stress of a metal plate after a pretreatment process.

Referring to FIGS. 4 and 5, the metal plate 100 may have a thickness of about 30 $\mu$m or less as a metal plate for manufacturing the deposition mask 100 for realizing a high resolution of 400 PPI or more. Specifically, the metal plate 100 may have a thickness of about 5 $\mu$m to about 30 $\mu$m through the pretreatment process described above. More specifically, the metal plate 100 may have a thickness of about 15 $\mu$m to about 25 $\mu$m through the pretreatment process described above.

In order to measure the residual stress of the metal plate 100, a sample metal plate 150 having a predetermined size is separated from the metal plate 100. The sample metal plate 150 is a sample collected at an arbitrary point of the metal plate 100. In this case, the sample metal plate 150 may be at least one sample collected at an arbitrary point of the metal plate 100, and the residual stress is measured using the at least one sample.

Specifically, a sample metal plate in a form of a strip having a horizontal width greater than a vertical length is extracted at an arbitrary point of the metal plate 100. Specifically, a first sample metal plate is extracted so that a long width region has a first region as shown in FIG. 4 and a second sample metal plate is extracted so that a long width region has a second region as shown in FIG. 5.

The sample metal plate 150 has a set size. Specifically, a length of a first region of the first sample metal plate is X mm and a length of a second region of the first sample metal plate is Y mm. In addition, a length of the first region of the second sample metal plate is about Y mm and a length of the second region of the second sample metal plate is about X mm.

In this case, X is 200 mm to 220 mm, and Y is 140 mm to 160 mm.

For example, the first sample metal plate may be a sample with a size of 210 mm*150 mm (horizontal*vertical). In addition, the second sample metal plate may be a sample with a size of 150 mm*210 mm (horizontal*vertical).

Next, the sample metal plate 150 is etched. In detail, one surface of the sample metal plate 150 is partially etched. For example, one surface of each of the first sample metal plate and the second sample metal plate is partially etched.

In detail, the sample metal plate 150 partially etches a region after 5% to 10% of a length of a long width region while remaining a region from one end of the long width region to 5% to 10% of the long width region of the sample metal plate 150. In detail, the sample metal plate 150 may be partially etched so that the thickness of the region after 5% to 10% of the long width region length of the sample metal plate 150 is about 30% to about 70% of the thickness of the sample metal plate 150. In more detail, the sample metal plate 150 may be partially etched so that the thickness of the region after 5% to 10% of the long width region length of the sample metal plate 150 is about 50% of the thickness of the sample metal plate 150.

Subsequently, the residual stress of the metal plate 100 is measured using the sample metal plate 150. Referring to FIG. 6, the sample metal plate 150 is placed on a horizontal table 200 in order to measure the residual stress of the sample metal plate 150. Specifically, the first sample metal plate and the second sample metal plate on which the above-described partial etching has been performed are placed on the horizontal table.

The sample metal plate 150 includes one surface and the other surface. In detail, the sample metal plate 150 includes one surface on which partial etching has been performed and the other surface on which partial etching has not been performed. The sample metal plate 150 is disposed so that the other surface of the sample metal plate 150 faces an upper surface of the horizontal table 200.

Next, a first residual stress and the second residual stress are measured. The first residual stress is a residual stress of the first sample metal plate, and the second residual stress is a residual stress of the second sample metal plate.

Specifically, the first residual stress is the residual stress of the first sample metal plate with the first region having a long width, and the second residual stress is the residual stress of the second sample metal plate with the second region having a long width.

The sample metal plate 150 mounted on the horizontal table may be bent in a region by internal stress of the metal plate and internal stress changed by the pretreatment process. In detail, at least one end of the etching region of the sample metal plate 150 may be bent in a region away from the upper surface of the horizontal table 200. In more detail, at least one end of one surface of a half-etched sample metal plate 150 may be bent toward a center region of the sample metal plate 150 while being spaced apart from the upper surface of the horizontal table 200. That is, one end of the sample metal plate 150 may be bent in a region away from the horizontal table by the internal stress, and the one end may be bent in a roll shape according to a magnitude of the internal stress.

That is, the residual stress of the metal plate 100 is calculated by measuring a height of the partially etched region of the sample metal plate 150 spaced apart from the upper surface of the horizontal table.

In detail, the residual stress of the metal plate 100 is defined as a maximum height at which the etched region of the sample metal plate is bent up from the upper surface of the horizontal table. In detail, the residual stress of the metal plate 100 can be defined by Equation 1 below.

[Equation 1]

$$\text{residual stress} = H / L$$

(H is a maximum height (mm) at which an etched region of a sample metal plate is bent up from an upper surface of the horizontal table, and L is a length (mm) of a first region in which an etched region is formed in a sample metal plate)

According to Equation 1, when the length of the first region of the first sample metal plate is X mm, the length of the second region of the first sample metal plate is Y mm, the length of the first region of the second sample metal plate is about Y mm and the length of the second region of the second sample metal plate is about X mm, the metal plate 100 has a first residual stress of H/X in the first region and a second residual stress of H/Y in the second region.

For example, when the first sample metal plate is a sample with a size of 210mm*150mm (horizontal*vertical), and the second sample metal plate is a sample with a size of 150mm*210mm (horizontal*vertical), the metal plate 100 has a first residual stress of H/210 in the first region and a second residual stress of H/150 in the second region.

The residual stress of the metal plate 100 is calculated using a plurality of sample metal plates 150. For example, the first residual stress of the first sample metal plate is a value derived from an average value of a plurality of first sample metal plates measured by the method described above. In addition, the second residual stress of the second sample metal plate is a value derived from an average value of a plurality of second sample metal plates measured by the method described above. That is, the residual stress is an average residual stress.

A first residual stress of a first region of the metal plate 100 and a second residual stress of the second region of the metal plate 100 are measured by the method. Specifically, the first residual stress is measured through the first sample metal plate, and the second residual stress is measured through the second sample metal plate.

A magnitude of the first residual stress and a magnitude of the second residual stress have a set magnitude.

The first residual stress and the second residual stress may be 10 mm or less. Specifically, the first residual stress and the second residual stress may be 7 mm or less. More specifically, the first residual stress and the second residual stress may be 5 mm or less. More specifically, the first residual stress and the second residual stress may be 1 mm to 5 mm.

If the magnitudes of the first residual stress and the second residual stress exceed 10 mm, the waviness of the metal plate may increase due to the residual stress inside the metal plate. Accordingly, when the deposition mask is manufactured using the metal plate, straightness characteristics of the manufactured deposition mask may decrease.

In addition, the magnitude of the first residual stress is different from the magnitude of the second residual stress. Specifically, the magnitude of the first residual stress is greater than the magnitude of the second residual stress. For example, a ratio of the magnitude of the first residual stress and the magnitude of the second residual stress may be 1 :(0.2 to 0.7). Specifically, a ratio of the magnitude of the first residual stress and the magnitude of the second residual stress may be 1:(0.3 to 0.6). More specifically, a ratio of the magnitude of the first residual stress and the magnitude of the second residual stress may be 1 :(0.4 to 0.5).

For example, the magnitude of the first residual stress may be 1 mm to 10 mm. Specifically, the magnitude of the first residual stress may be 1.5 mm to 7.5 mm. More specifically, the magnitude of the first residual stress may be 2 mm to 5 mm.

In addition, the magnitude of the second residual stress may be 0.5 mm to 8 mm. Specifically, the magnitude of the second residual stress may be 0.5 mm to 5 mm. More specifically, the magnitude of the second residual stress may be 1 mm to 3 mm.

The metal plate according to an embodiment may control residual stress and waviness of the metal plate remaining after the pretreatment process within a set range, and may improve a problem of a gap between the deposition mask manufactured by the metal plate and the deposition substrate. Therefore, when the organic material is deposited on the deposition substrate through the deposition mask manufactured by the metal plate, the deposition efficiency is improved.

Meanwhile, the metal plate according to an embodiment has a waviness in a set size range. That is, the metal plate according to an embodiment has a residual stress in a set size range. Alternatively, the metal plate according to an embodiment has a waviness in a set size range. Alternatively, the metal plate according to an embodiment has a residual stress and waviness in a set size range.

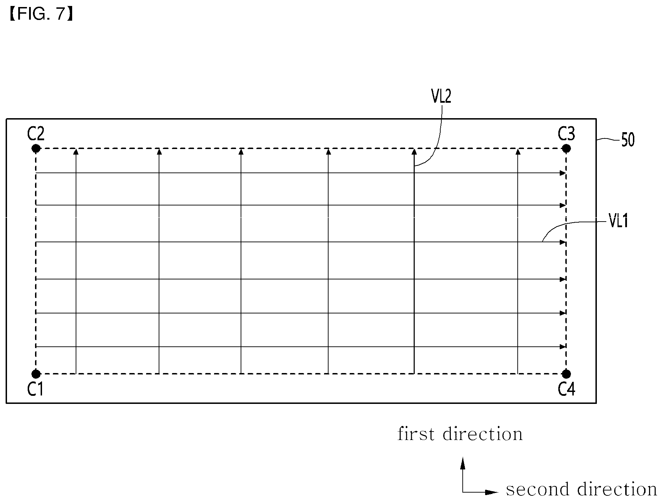

FIG. 7 is a view illustrating a method of measuring the waviness of a metal plate according to an embodiment.

Referring to FIG. 7, the waviness of the metal plate is to measure the flatness of the metal plate, and may be measured using a non-contact 3D measuring device. That is, a plurality of coordinates spaced at equal intervals can be set on the metal plate, and the size of flatness can be converted to length and measured using these.

Referring to FIG. 7, the sample metal plate 150 having a size set in the metal plate 100 is separated to measure the waviness of the metal plate 100. The sample metal plate 150 is a sample collected at an arbitrary point of the metal plate 100. In this case, the sample metal plate 150 may be at least one sample collected at an arbitrary point of the metal plate 100, and the waviness is measured using the at least one sample.

Specifically, a sample metal plate in a form of a strip having a horizontal width greater than a vertical length is extracted at an arbitrary point of the metal plate 100. Specifically, as shown in FIG. 7, a third sample metal plate is extracted so that a long width region has the first region.

The sample metal plate 150 has a predetermined size. Specifically, a length of the first region of the third sample metal plate is A mm and a length of the second region is B mm. In this case, A is 490 mm to 510 mm, and B is 160 mm to 180 mm.

For example, the third sample metal plate may be a sample having a size of 500 mm×170 mm (horizontal*vertical).

A plurality of coordinates are set in the third sample metal plate. That is, a first coordinate C1, a second coordinate C2, a third coordinate C3, and a fourth coordinate C4 are set in the third sample metal plate.

In In addition, a plurality of coordinates are set inside a virtual square formed by connecting the first coordinate C1, the second coordinate C2, the third coordinate C3, and the fourth coordinate C4.

The waviness of the metal plate 100 may be measured through a ratio of a curved distance and a straight line distance of the coordinates. Specifically, the first waviness of the first region and the second waviness of the second region are defined by Equation 2 below.

[Equation 2]

$$\text{waviness (ppm)} = 10^6 * (L-L_0)/L_0$$

(L is a curved distance of the coordinates, and $L_0$ is a straight line distance of the coordinates.)

The waviness of the first region of the metal plate 100 is calculated based on an average value of the waviness of first virtual lines VL1 of the first region passing through the coordinates, and the waviness of the second region is calculated based on an average value of the waviness of second virtual lines VL2 of the second region passing through the coordinates.

The first waviness of the first region of the metal plate 100 and the second waviness of the second region are measured by the method.

A size of the first waviness and a size of the second waviness have a set size.

The first waviness and the second waviness may be 25 ppm or less. In detail, the first waviness and the second waviness may be 20 ppm or less. In more detail, the first waviness and the second waviness may be 5 ppm to 25 ppm.

When the sizes of the first waviness and the second waviness exceed 25 ppm, the flatness of the surface of the metal plate is deteriorated. Accordingly, when an organic material is deposited on a deposition substrate using the deposition mask manufactured using the metal plate, a gap between the deposition mask and the deposition substrate increases, and thus the deposition efficiency may be deteriorated.

Also, the size of the first waviness is different from the size of the second waviness. Specifically, the size of the first waviness is larger than the size of the second waviness. For example, a ratio of the size of the first waviness and the size of the second waviness may be 1 :(0.15-0.7). Specifically, a ratio of the size of the first waviness to the size of the second waviness may be 1 :(0.2-0.6). More specifically, a ratio of the size of the first waviness and the size of the second waviness may be 1 :(0.25-0.5).

For example, the size of the first waviness may be 8 ppm to 25 ppm. Specifically, the size of the first waviness may be 10 ppm to 20 ppm. In more detail, the size of the first waviness may be 12 ppm to 18 ppm.

Also, the size of the second waviness may be 3 ppm to 25 ppm. Specifically, the size of the second waviness may be 5 ppm to 15 ppm. More specifically, the size of the second waviness may be 7 ppm to 10 ppm.

The metal plate according to an embodiment may control residual stress and waviness of the metal plate remaining after the pretreatment process within a set range, and may improve a problem of a gap between the deposition mask manufactured by the metal plate and the deposition substrate. Therefore, when the organic material is deposited on the deposition substrate through the deposition mask manufactured by the metal plate, the deposition efficiency is improved.

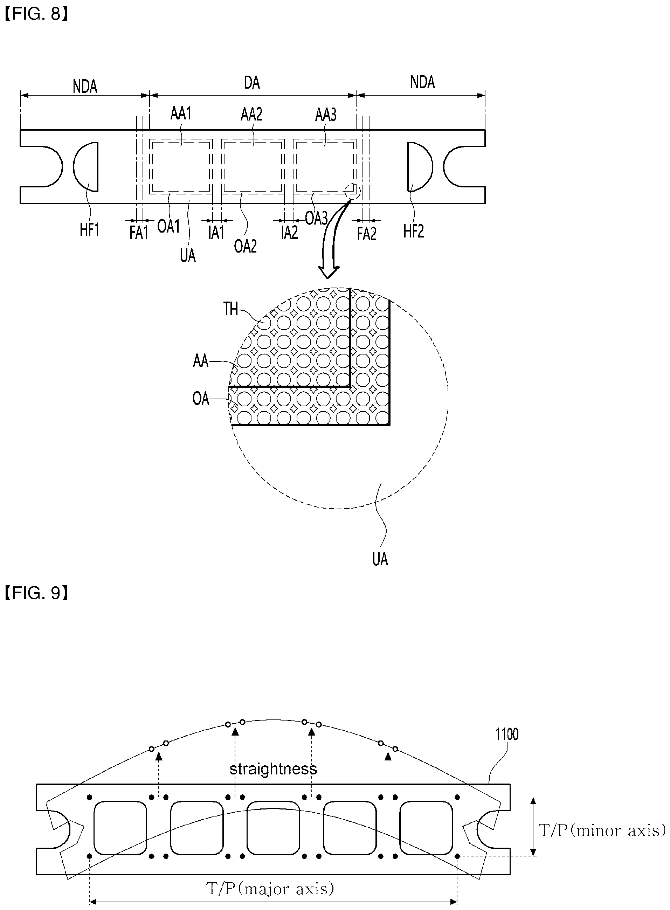

Hereinafter, with reference to FIG. 8, a deposition mask to which the above-described pre-treated metal plate is applied will be described.

FIG. 8 is a plan view of a deposition mask according to an embodiment.

Referring to FIG. 8, the deposition mask 1100 according to an embodiment includes a deposition region DA and a non-deposition region NDA.

The deposition region DA is a region for forming a deposition pattern. That is, a deposition material is deposited on a deposition substrate through the deposition region DA through the deposition mask.

The deposition mask 1100 includes a plurality of deposition regions DA. For example, the deposition region DA includes an effective part and a non-effective part. In detail, the deposition region DA includes a plurality of effective parts capable of forming a deposition pattern by forming a plurality of through holes and a non-effective part UA in which no through holes are formed. A plurality of through holes TH described above are formed in the effective part.

The plurality of effective parts may include a first effective part AA1, a second effective part AA2, and a third effective part AA3 spaced apart from each other by separation regions IA1 and IA2.

In a case of a small-sized display device such as a smartphone, any one effective part of a plurality of deposition regions included in the deposition mask 1100 may be for forming one display device. Alternatively, in a case of a large-sized display device such as a television, a plurality of effective parts included in one deposition mask 1100 may be a portion for forming one display device. Accordingly, one deposition mask 1100 may include a plurality of effective parts, and thus a plurality of display devices may be simultaneously formed. Accordingly, the deposition mask 1100 according to an embodiment may improve process efficiency.

The non-deposition region NDA is disposed at both sides of a length region of the deposition region DA. That is, the non-deposition region NDA is disposed outside the length region of the deposition region DA.

The non-deposition region NDA is a region that is not involved in deposition. The non-deposition region NDA includes a frame fixing region FA1 and FA2 for fixing the deposition mask 1100 to the mask frame 1200. Also, the non-deposition region NDA includes half etching parts HF1 and HF2, open parts OA1 and OA2, and protrusion parts PA1 and PA2.

The deposition mask 1100 according to an embodiment is manufactured by the metal plate 100 described above. Accordingly, since the metal plate for manufacturing the deposition mask has low residual stress and waviness, straightness and total pitch (T/P) characteristics of the deposition mask manufactured thereby are also improved.

FIG. 9 is a view for explaining a straightness and a total pitch (T/P) of the deposition mask 1100 according to an embodiment.

Referring to FIG. 9, a deposition mask 1100 before and after bending is illustrated. The straightness and the total pitch of the deposition mask 1100 are calculated by a difference in positions of the deposition mask 1100 before and after bending.

In detail, the straightness of the deposition mask 1100 is measured to be the degree of bending of the deposition mask. In detail, the straightness of the deposition mask 1100 is measured based on the degree of bending of the deposition mask after bending when the degree of bending of the deposition mask before bending is set to 0. In more detail, the straightness of the deposition mask 1100 is measured based on a maximum degree of bending of the deposition mask after bending when the degree of bending of the deposition mask before bending is set to 0.

The deposition mask 1100 manufactured using the metal plate 100 may have a straightness size of less than 50 $\mu$m. That is, the maximum bending size of the deposition mask 1100 may be less than 50 $\mu$m. Specifically, the deposition mask 1100 manufactured using the metal plate 100 may have a straightness size of 40 $\mu$m or less. In more detail, the deposition mask 1100 manufactured using the metal plate 100 may have a straightness of 15 $\mu$m to 40 $\mu$m. In more detail, the deposition mask 1100 manufactured using the metal plate 100 may have a straightness of 25 $\mu$m to 35 $\mu$m.

In addition, the total pitch is measured based on a difference between a length of an upper surface and a length of a lower surface of the deposition mask along a major axis or a minor axis region.

The deposition mask 1100 manufactured using the metal plate 100 may have a total pitch size of less than 30 μm. Specifically, the deposition mask 1100 manufactured using the metal plate 100 may have a total pitch size of 20 μm or less. In more detail, the deposition mask 1100 manufactured using the metal plate 100 may have a total pitch of 15 μm to 25 μm.

The deposition mask according to the embodiment is manufactured using a metal plate with reduced residual stress and waviness. Accordingly, the straightness characteristics and total pitch characteristics of the deposition mask manufactured from the metal plate can be improved. In detail, the straightness and total pitch of deposition marks can be reduced.

Accordingly, the deposition mask according to an embodiment has a reduced warpage. Therefore, when the deposition mask and the deposition substrate contact each other, the gap between the deposition region of the deposition mask and the deposition substrate may be minimized.

Accordingly, the deposition mask according to the embodiment can improve deposition efficiency by minimizing the gap between the deposition mask and the deposition substrate, thereby minimizing non-uniformity in the deposition thickness.

In addition, a separate tensile process to reduce the waviness of the above deposition mask may be omitted after forming the above deposition mask.

Features, structures, effects, etc. described in the above embodiments are included in at least one embodiment, and it is not necessarily limited to only one embodiment. Furthermore, features, structures, effects, etc. illustrated in each embodiment can be combined or modified for other embodiments by those of ordinary skill in the art to which the embodiments belong. Accordingly, the contents related to such combinations and variations should be interpreted as being included in the scope of the embodiments.

In the above, the embodiment has been mainly described, but this is only an example and does not limit the embodiment, and those of ordinary skill in the art to which the embodiment pertains will appreciate that various modifications and applications not illustrated above are possible without departing from the essential characteristics of the present embodiment. For example, each component specifically shown in the embodiment can be implemented by modification. And the differences related to these modifications and applications should be interpreted as being included in the scope of the embodiments set forth in the appended claims.

**Claims**

1. A metal plate used to manufacture a deposition mask for OLED pixel deposition, the metal plate comprising:

   a first region; and
   a second region intersecting the first region,
   wherein the metal plate includes an invar containing iron and nickel,
   wherein a first residual stress of the first region and a second residual stress of the second region are 5 mm or less,
   wherein a ratio of the first residual stress and the second residual stress is 1:0.2 to 0.7,
   wherein the first residual stress is a residual stress of an arbitrary first sample metal plate of a size of X mm*Y mm (horizontal*vertical) in which the first region is a horizontal region,
   wherein the second residual stress is a residual stress of an arbitrary second sample metal plate of a size of Y mm*X mm (horizontal*vertical) in which the second region is a horizontal region,
   wherein the X is 200 mm to 220 mm, and the Y is 140 mm to 160 mm, and
   wherein the residual stress is defined by Equation 1 below when a thickness of a region after 5% to 10% of a length of a long width region from one end of each of the first sample metal plate and the second sample metal plate is etched to be 30% to 70% of a thickness of the metal plate and etched sample metal plates are mounted on a horizontal table.

[Equation 1]

$$\text{residual stress} = H/L$$

(H is a maximum height (mm) at which an etched region of a sample metal plate is bent up from an upper surface of the horizontal table, and L is a length (mm) of a first region in which an etched region is formed in a sample metal plate)

2. The metal plate of claim 1, wherein the ratio of the first residual stress and the second residual stress is 1:0.3 to 0.6.

3. The metal plate of claim 1, wherein the ratio of the first residual stress and the second residual stress is 1:0.4 to 0.5.

4. The metal plate of claim 1, wherein the first residual stress is measured based on an average value of a plurality of first sample metal plates, and wherein the second residual stress is measured based on an average value of a plurality of second sample metal plates.

5. The metal plate of claim 1, wherein a first waviness of the first region and a second waviness of the second region are 20 ppm or less,

> wherein a ratio of the first waviness and the second waviness is 1 :0.15 to 0.7,
> wherein the first waviness is a waviness of the first region of an arbitrary third sample metal plate with a size of 500mm*170mm (horizontal*vertical) in which the first region is a horizontal region,
> wherein the second waviness is a waviness of the second region of the third sample metal plate,
> wherein the third sample metal plate includes a virtual square formed by a first coordinate (C1), a second coordinate (C2), a third coordinate (C3), and a fourth coordinate (C4), and a plurality of coordinates spaced at equal intervals within the virtual square,
> wherein a plurality of first virtual lines of the first region and a plurality of second virtual lines of the second region passing through the coordinates are set on the third sample metal plate, and
> wherein the first waviness and the second waviness are defined by Equation 2 below.

[Equation 2]

$$\text{waviness (ppm)} = 106 * (L-L0)/L0$$

(L is a curved distance of the coordinates, and L0 is a straight line distance of the coordinates.)

6. The metal plate of claim 5, wherein the ratio of the first waviness and the second waviness is 1:0.2 to 0.6.

7. The metal plate of claim 5, wherein the ratio of the first waviness and the second waviness is 1:0.25 to 0.5.

8. The metal plate of claim 5, wherein the first waviness is calculated based on an average value of a waviness of each of the first virtual lines passing through the coordinates, and
wherein the second waviness is calculated based on an average value of a waviness of each of the second virtual lines passing through the coordinates.

9. The metal plate of claim 1, wherein the thickness of the metal plate is 15 $\mu$m to 25 $\mu$m.

10. The metal plate of claim 1, wherein the first residual stress is 2 mm to 5 mm, and
wherein the second residual stress is 1 mm to 3 mm.

11. The metal plate of claim 2, wherein the first waviness is 10 ppm to 20 ppm, and
wherein the second waviness is 5 ppm to 15 ppm.

12. A deposition mask comprising:

> a metal plate of any one of claims 1 to 5,
> wherein the metal plate includes:

> > a through hole including a first surface hole on a first surface of the metal plate and a large surface hole on a second surface of the metal plate, and
> > wherein a width of the first surface hole may be smaller than a width of the second surface hole.

13. The deposition mask of claim 12, wherein the deposition mask has a straightness of 25 $\mu$m to 35 $\mu$m, and
wherein the straightness is defined as a maximum bending degree of the deposition mask after bending of the deposition mask when a bending degree of the deposition mask before bending is set to 0.

14. The deposition mask of claim 12, wherein the deposition mask has a total pitch of 15 $\mu$m to 25 $\mu$m, and
wherein the total pitch is defined as a difference between a length of an upper surface and a length of a lower surface of the deposition mask along a major axis or a minor axis region.

【FIG. 1】

1000

1300
1100
1200
1500
1400

【FIG. 2】

【FIG. 3】

【FIG. 4】

first direction

second direction

【FIG. 5】

first direction

second direction

【FIG. 6】

【FIG. 7】

first direction

second direction

【FIG. 8】

【FIG. 9】

## INTERNATIONAL SEARCH REPORT

| International application No. |
|---|
| **PCT/KR2022/018858** |

| A. | CLASSIFICATION OF SUBJECT MATTER |
|---|---|

**H10K 99/00**(2023.01)i; **H10K 71/00**(2023.01)i; **C23C 14/04**(2006.01)i

According to International Patent Classification (IPC) or to both national classification and IPC

| B. | FIELDS SEARCHED |
|---|---|

Minimum documentation searched (classification system followed by classification symbols)

H10K 99/00(2023.01); B01D 39/02(2006.01); C23C 14/04(2006.01); C25D 1/08(2006.01); H01L 21/66(2006.01); H01L 51/00(2006.01); H01L 51/56(2006.01)

Documentation searched other than minimum documentation to the extent that such documents are included in the fields searched

Korean utility models and applications for utility models: IPC as above
Japanese utility models and applications for utility models: IPC as above

Electronic data base consulted during the international search (name of data base and, where practicable, search terms used)

eKOMPASS (KIPO internal) & keywords: 금속판(metal plate), 증착용 마스크(deposition mask), 인바(Invar), 잔류응력 (residual stress), 표면 파형(waviness)

| C. | DOCUMENTS CONSIDERED TO BE RELEVANT |
|---|---|

| Category* | Citation of document, with indication, where appropriate, of the relevant passages | Relevant to claim No. |
|---|---|---|
| A | KR 10-2019-0058055 A (LG INNOTEK CO., LTD.) 29 May 2019 (2019-05-29)<br>See claims 6 and 10. | 1-14 |
| A | KR 10-2016-0126807 A (LG INNOTEK CO., LTD.) 02 November 2016 (2016-11-02)<br>See entire document. | 1-14 |
| A | KR 10-2187007 B1 (PIMS INC.) 04 December 2020 (2020-12-04)<br>See entire document. | 1-14 |
| A | JP 2019-007083 A (DAINIPPON PRINTING CO., LTD.) 17 January 2019 (2019-01-17)<br>See entire document. | 1-14 |
| A | KR 10-2021-0038528 A (LG INNOTEK CO., LTD.) 07 April 2021 (2021-04-07)<br>See entire document. | 1-14 |

| ☐ Further documents are listed in the continuation of Box C. | ☑ See patent family annex. |
|---|---|

| * | Special categories of cited documents: |
|---|---|
| "A" | document defining the general state of the art which is not considered to be of particular relevance |
| "D" | document cited by the applicant in the international application |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| "T" | later document published after the international filing date or priority date and not in conflict with the application but cited to understand the principle or theory underlying the invention |
|---|---|
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
|---|---|
| **02 March 2023** | **02 March 2023** |

| Name and mailing address of the ISA/KR | Authorized officer |
|---|---|
| **Korean Intellectual Property Office**<br>**Government Complex-Daejeon Building 4, 189 Cheongsa-ro, Seo-gu, Daejeon 35208** | |
| Facsimile No. **+82-42-481-8578** | Telephone No. |

Form PCT/ISA/210 (second sheet) (July 2022)

EP 4 451 833 A1

**INTERNATIONAL SEARCH REPORT**
Information on patent family members

International application No.

**PCT/KR2022/018858**

| Patent document cited in search report | | | Publication date (day/month/year) | Patent family member(s) | | | Publication date (day/month/year) |
|---|---|---|---|---|---|---|---|
| KR | 10-2019-0058055 | A | 29 May 2019 | None | | | |
| KR | 10-2016-0126807 | A | 02 November 2016 | KR | 10-2021-0144630 | A | 30 November 2021 |
| KR | 10-2187007 | B1 | 04 December 2020 | CN | 113308666 | A | 27 August 2021 |
| JP | 2019-007083 | A | 17 January 2019 | CN | 108138303 | A | 08 June 2018 |
| | | | | CN | 108138303 | B | 25 December 2020 |
| | | | | EP | 3358038 | A1 | 08 August 2018 |
| | | | | EP | 3358038 | A4 | 01 January 2020 |
| | | | | EP | 3358038 | B1 | 18 January 2023 |
| | | | | EP | 3757247 | A1 | 30 December 2020 |
| | | | | JP | 2017-057621 | A1 | 14 December 2017 |
| | | | | JP | 6443457 | B2 | 26 December 2018 |
| | | | | JP | 6939732 | B2 | 22 September 2021 |
| | | | | KR | 10-2018-0043816 | A | 30 April 2018 |
| | | | | KR | 10-2020-0137032 | A | 08 December 2020 |
| | | | | KR | 10-2022-0025944 | A | 03 March 2022 |
| | | | | KR | 10-2366712 | B1 | 23 February 2022 |
| | | | | KR | 10-2477941 | B1 | 16 December 2022 |
| | | | | TW | 201726950 | A | 01 August 2017 |
| | | | | TW | I604074 | B | 01 November 2017 |
| | | | | US | 10538838 | B2 | 21 January 2020 |
| | | | | US | 11118258 | B2 | 14 September 2021 |
| | | | | US | 2018-0334740 | A1 | 22 November 2018 |
| | | | | US | 2019-0169733 | A1 | 06 June 2019 |
| | | | | WO | 2017-057621 | A1 | 06 April 2017 |
| KR | 10-2021-0038528 | A | 07 April 2021 | KR | 10-2023-0007292 | A | 12 January 2023 |

Form PCT/ISA/210 (patent family annex) (July 2022)

18